# EUROPÄISCHE PATENTSCHRIFT

(11) **EP 1 814 124 B1**
(45) Veröffentlichungstag und Bekanntmachung des Hinweises auf die Patenterteilung: **31.03.2010**
(21) Anmeldenummer: 07100016.0
(22) Anmeldetag: 02.01.2007
(51) Int. Cl.: G11C 17/16, G11C 17/18

(54) **Baugruppe mit mechanisch unzugänglicher oder schwer zugänglicher Schaltung sowie Verfahren zur Umschaltung des Betriebszustandes einer Baugruppe**
Assembly with mechanically inaccessible or not easily accessible switching and method for switching the operating mode an assembly
Composant doté d'un circuit mécaniquement non accessible ou difficilement accessible tout comme procédé destiné au convertissement de l'état de fonctionnement d'un composant

(30) Priorität: 13.01.2006 DE 102006001729
(43) Veröffentlichungstag der Anmeldung: 01.08.2007
(73) Patentinhaber: ROBERT BOSCH GMBH, 70442 Stuttgart (DE)
(72) Erfinder: Woyda-Wolf, Martin, 82064 Strasslach-Dingharting (DE)

(56) Entgegenhaltungen:
- EP-A- 0 652 567
- DE-A1- 10 160 113
- GB-A- 2 409 117
- US-A1- 2005 002 262
- US-A1- 2005 151 578
- US-B1- 6 437 959

## Beschreibung

### Stand der Technik

Die Erfmdung betrifft eine Baugruppe mit einer mechanisch unzugänglich oder schwer zugänglich angeordneten Schaltung, die ein durch einen Stromimpuls irreversibel änderbares elektrisches Bauteil aufweist, wobei durch die irreversible Änderung des Bauteils die Schaltung von einem ersten Betriebszustand in einen zweiten Betriebszustand umschaltbar ist sowie ein Verfahren zur Umschaltung des Betriebszustandes einer Baugruppe.

Bei einer Vielzahl von Applikationen werden Baugruppen erst bei der Inbetriebnahme oder Montage für ihren Einsatzzweck endgültig konfiguriert. Durch die Verwendung von adaptierbaren Schaltungen können sich Hersteller die Produktion und die Lagerhaltung einer Vielzahl von fest verkabelten Baugruppenvarianten sparen und stattdessen eine einzige konfigurierbare Baugruppe verfügbar halten.

Es ist beispielsweise üblich, Teile einer Kommunikationsanlage bei der Installation an spezielle Erfordernisse anzupassen. Die Anpassung erfolgt dabei oftmals über sogenannte Jumper, also steckbare Überbrückungskontakte, Kodierschalter oder andere mechanische Bauteile. Auch das Einsetzen von unterschiedlich programmierten Speicherbausteinen ist als übliches Verfahren bekannt.

Die Druckschrift US 6,437,959 B1 betrifft ein elektrisches bzw. elektronisches System, welches mindestens ein funktionales Modul und eine Isoliereinheit in Form eines irreversibel änderbaren elektrischen Bauteils aufweist, wobei die Isoliereinheit ausgebildet ist, eine Signalzuleitung zur Übergabe von Signalen zur Einstellung des mindestens einen funktionalen Moduls durch ein Zerstören der Isoliereinheit zu unterbrechen. Die Umschaltung von verschiedenen Betriebszuständen des mindestens einen funktionalen Moduls erfolgt durch Übertragung von entsprechenden Signalen an das funktionale Modul vor dem Unterbrechen der Signalleitung.

Aus der Druckschrift EP 0 652 567 A2, auf der der Oberbegriff des Anspruchs 1 bekannt ist eine Vorrichtung und ein Verfahren zur Anpassung von analogen integrierten Schaltungen auf einem Chip bekannt, die in einem Kunststoffgehäuse gekapselt sind. Zu diesem Zweck weist der Chip neben der eigentlichen Schaltung eine Anpassungsschaltung mit einem unterbrechbaren, elektrischen Element, wie z.B. einer Sicherung, einer Statuserkennungseinheit zum Erkennen des Status des elektrischen Elements, einer Stromquelle zur Erzeugung eines Stromes zur Unterbrechung des elektrischen Elements sowie einer Testzustandserkennungseinheit, die auch teilunterbrochene elektrische Elemente erkennt, auf. Die eigentliche Schaltung und die Anpassungsschaltung sind gemeinsam auf dem gleichen Chip angeordnet und werden gemeinsam in dem Kunststoffgehäuse verkapselt.

### Offenbarung der Erfindung

Erfindungsgemäß wird eine Baugruppe mit einer mechanisch unzugänglich oder schwer zugänglich angeordneten Schaltung mit den Merkmalen des Anspruchs 1 und ein Verfahren zur Umschaltung des Betriebszustandes einer Baugruppe mit den Merkmalen des Anspruchs 10 vorgeschlagen. Die Unteransprüche betreffen vorteilhafte und/oder bevorzugte Ausführungsformen.

Die erfindungsgemäße Baugruppe umfasst eine Schaltung, wobei die Schaltung in der Baugruppe mechanisch unzugänglich oder mechanisch schwer zugänglich angeordnet ist. Die mangelnde, also die fehlende oder schlechte Zugänglichkeit kann dadurch begründet sein, dass die Schaltung nur durch einen irreversiblen mechanischen Zugriff erreichbar ist und/oder dass es eine Vielzahl von Arbeitsschritten erfordert, um auf die Schaltung mechanisch zuzugreifen und/oder dass die Schaltung gekapselt ist, insbesondere vergossen und/oder abgedichtet ausgebildet ist.

Die Schaltung ist bevorzugt als bestückte Leiterplatte und/oder bestücktes Substrat, insbesondere in zwei- oder dreidimensionaler Anordnung ausgebildet. Bevorzugt weist die Schaltung eine Vielzahl von elektrischen oder elektronischen Einzelkomponenten, wie z.B. Widerstände, Kondensatoren, Transistoren auf, die über ein Verbindungsverfahren, wie z.B. Löten oder Schweißen, miteinander verbunden sind.

Die Schaltung weist ein Bauteil auf, welches durch einen Stromimpuls irreversibel änderbar ist, wobei die Änderung insbesondere durch die thermische Energie erfolgt, die bei der Führung des Stromimpulses durch einen Leiter entsteht. Bevorzugt weist das Bauteil zwei diskrete Zustände auf.

Das Bauteil ist in der Schaltung so angeordnet und/oder verschaltet, dass durch dessen Änderung die Schaltung von einem ersten Betriebszustand in einen zweiten Betriebszustand umschaltbar ist, wobei jeweils von funktionierenden Betriebszuständen ausgegangen wird. Bei Änderungen der Betriebszustände werden vorzugsweise elektrische/elektronische Parameter, wie z.B. Höhe der Versorgungsspannung, Frequenz der Versorgungsspannung und/oder informationstechnische Parameter, wie z.B. die Anzahl von aktivierten Informationskanälen, die Auswahl eines Übertragungsprotokolls oder eines Softwaremoduls, geändert.

Bei alternativen Ausführungsformen können eine Vielzahl von derartigen Bauteilen und/oder Bauteile mit mehr als zwei diskreten Zuständen vorgesehen sein, um zwischen mehr als zwei Betriebszuständen der Schaltung umzuschalten.

Erfindungsgemäß ist vorgesehen, dass die Baugruppe mechanisch zugängliche Zuleitungen aufweist, über die der Stromimpuls zur irreversiblen Änderung des elektrischen Bauteils zuführbar ist. Die Zuleitungen führen insbesondere mindestens aus der mechanisch unzugänglichen und/oder schwer zugänglichen Schaltung heraus und sind von außen und/oder extern der Baugruppe mechanisch zugänglich. Die mechanische Zugänglichkeit ist gegeben, wenn die Zuleitungen mechanische Schnittstellen, wie z.B. Buchsen, Stecker oder auch nur freie Kabelenden aufweisen und/oder als solche ausgebildet sind.

Die Erfindung geht dabei von der Überlegung aus, dass ein großes Einsparungspotential von Fertigungs- und Logistikaufwendungen vorliegt, wenn es gelingt, dass Baugruppen nur in einer einzigen Variante gefertigt und gehandelt werden und dann bei der Montage ohne besonderen Aufwand in eine andere Variante umgewandelt werden können. Dies wird erreicht, indem die Baugruppen mittels einen über mechanisch zugängliche Zuleitungen zuführbaren Stromimpuls angepasst werden können. Zudem soll diese Anpassung stabil sein und durch äußere Einflüsse (z.B. EMV) nicht rückgängig gemacht werden können, was durch die Verwendung eines irreversibel änderbaren Bauteiles erreicht wird. Ein weiteres Sparpotential ist gegeben, wenn die Maßnahmen zur Umwandlung kostengünstig realisiert werden können. Durch die Verwendung von mechanischen zugänglichen Zuleitungen zum Umschalten der Betriebszustände, kann ein Gerät zum Umschalten, also das Gerät, das den notwendigen Stromimpuls erzeugt, mehrfach verwendet werden. Insbesondere wird die Schaltung in der erfindungsgemäßen Baugruppe nicht unnötig durch aufwändige Anpassungsschaltungen wie aus dem Stand der Technik bekannt in der Herstellung verteuert.

Bei einer vorteilhaften Weiterbildung weisen die Zuleitungen mindestens eine Doppelfunktion, also mindestens zwei elektrische Funktionen und/oder Funktionalitäten, auf, wobei die erste Funktion als Zuführung des Stromimpulses für die irreversible Änderung des elektrischen Bauteiles realisiert ist.

Dieser Erfindungsausbildung liegt die Idee zu Grunde, dass bei Baugruppen die Anzahl der elektrischen Schnittstellen, also der Zuleitungen und/oder der Buchsen o.ä., limitiert sein soll. Zum einen bedeuten eine größere Anzahl von Schnittstellen eine Erhöhung des Fertigungsaufwandes, zum anderen fördert die Verminderung von elektrischen Schnittstellen die einfache Montierbarkeit oder Integrierbarkeit von insbesondere gekapselten Baugruppen. Ferner ist zu berücksichtigen, dass insbesondere gekapselte Baugruppen oftmals abgedichtet sind und eine Verminderung der Schnittstellen das Risiko einer mangelnden Abdichtung verringert. Ein Vorteil der vorliegenden Ausbildung liegt somit darin, dass trotz der Möglichkeit der Umschaltung nur die für den Betrieb notwendigen elektrischen Schnittstellen, also insbesondere Anschlussdrähte, vorhanden sind.

Besonders bevorzugt ist es, wenn die Zuleitungen zur Realisierung der zweiten Funktion als Versorgungsspannungsleitungen ausgebildet sind, da diese zum Betrieb der Baugruppe in der Regel zwingend notwendig sind. Bevorzugt sind die Versorgungsspannungsleitungen und/oder die Schaltung als Niederspannungssystem, insbesondere mit und/oder für eine Gleichspannungsversorgung ausgebildet.

Dadurch, dass bei einer Weiterbildung der Erfindung die Schaltung so ausgebildet ist, dass durch Umpolung der Zuleitungen die Umschaltung des Betriebszustandes realisiert ist, wird eine besonders einfache und kostengünstige Maßnahme zur Umsetzung einer adaptierbaren Baugruppe vorgeschlagen. In einer Konkretisierung werden als umzupolende Zuleitungen die Versorgungsspannungsleitungen verwendet.

Anders ausgedrückt, wird die Änderung des Betriebszustandes der Schaltung und somit der Baugruppe erreicht, indem an die Anschlussdrähte der Baugruppe für die Gleichspannungsversorgung mit gegenüber dem normalen Betriebszustand vertauschter Polung eine Spannung angelegt wird, so dass es zu einem Stromfluss kommt, wobei der Stromfluss den Stromimpuls bildet. Durch den Stromimpuls wird das elektrische Bauteil irreversibel geändert, wobei die dadurch geänderte Schaltung im Betrieb ein geändertes Betriebsverhalten zeigt. Die Schaltung ist dabei vorzugsweise derart ausgebildet, dass eine für die irreversible Änderung des elektrischen Bauteils notwendige Länge und/oder Höhe des Stromimpulses so abgestimmt ist bzw. sind, dass eine unbeabsichtigte kurze Verpolung noch nicht zu der irreversiblen Änderung führt. Vorzugsweise wird die Mindestzeit für die Verpolung bei der für das Bauteil vorgesehenen Spannungsquelle mit mindestens 10s, vorzugsweise mindestens 20s, insbesondere mit mindestens 30s gewählt.

Bei der Konkretisierung der Schaltung wird als irreversibel änderbares Bauteil vorzugsweise eine Sicherung, insbesondere eine Schmelzsicherung gewählt. Insbesondere bei geringem Platzangebot kann eine SMD-Schmelzsicherung als elektrisches Bauteil verwendet werden.

Bevorzugt ist die Schaltung und/oder die Baugruppe ausgebildet, so dass der Stromimpuls über eine Serienschaltung eines internen Selektionselements und des elektrischen Bauteils führbar ist und/oder geführt wird. Als internes Selektionselement wird insbesondere eine Diode, insbesondere eine Schottkydiode, eingesetzt. Die Diode ist dabei so verschaltet, dass bei normaler Versorgungsspannung die Diode in Sperrrichtung und bei verpolter, also invertierter Versorgungsspannung die Diode in Durchlassrichtung betrieben wird. Bei verpolter Versorgungsspannung wird somit ein Strom durch die Diode geleitet, der zu einer irreversiblen Änderung des in Serie geschalteten elektrischen Bauteils führt.

Alternativ ist das Selektionselement beispielsweise als kapazitives Koppelelement, insbesondere als in Serie geschalteter Kondensator ausgebildet, wenn die Baugruppe im normalen Betrieb mit Gleichspannung betreibbar ist. In diesem Fall wird der Stromimpuls in Form von Wechselspannung an das elektrische Bauteil geführt. Auch der umgedrehte Fall ist verwendbar, d.h. dass die Schaltung ausgebildet ist, dass die Baugruppe im normalen Betrieb mit Wechselspannung betreibbar ist und der Stromimpuls als Gleichspannungsimpuls ausgebildet ist. Weitere Alternativen des Selektionselements können unterschiedliche Frequenzen und/oder Amplituden von Versorgungsspannung und Stromimpuls zur Selektion ausnutzen.

Bei einer bevorzugten Ausführungsform der Baugruppe erfolgt die Änderung des Betriebszustandes über die Änderung und/oder Invertierung eines Logikzustandes. Diese Ausbildung hat den Vorteil, dass die Änderung des elektrischen Bauteils vergleichsweise ungenau erfolgen kann, da unterschiedliche Logikzustände einen großen Potentialabstand aufweisen und auch bei einer unvollkommenen Änderung des elektrischen Bauteils der Logikzustand geändert und/oder invertiert ist. Bevorzugt weist die Schaltung eine Verarbeitungseinheit, insbesondere eine programmierbare Verarbeitungseinheit, Mikrokontroller, CPU, DSP, FPGA, ASIC oder ähnliches, mit Logikeingängen auf.

Bei einer praktischen Weiterbildung der Baugruppe wird einem Eingang zur Änderung des Logikzustandes ein Transistor zur Invertierung des Logikzustandes vorgeschaltet. Diese Weiterbildung ist insbesondere sinnvoll, um die Schaltung flexibel an Randbedingungen der verwendeten Verarbeitungseinheiten anzupassen.

Bevorzugt ist die Baugruppe als insbesondere hermetisch gekapseltes, vorzugsweise vergossenes Klein- oder Niederspannungsgerät ausgebildet. Die Kapselung wird insbesondere als Vergießen z.B. mit einer Kunstharzmasse umgesetzt, wobei nach dem Vergießen die Schaltung mechanisch nicht mehr zugänglich ist. Bevorzugt ist die Schaltung wasserdicht vergossen und/oder weist als elektrische Schnittstellen nur und/oder ausschließlich die für den Betrieb im Betriebszustand notwendigen Zuleitungen auf. Die Versorgungsspannung des Niederspannungsgeräts ist bis zu 12V, vorzugsweise bis zu 24V, insbesondere bis zu 36V. Als Kleingeräte werden insbesondere Vorrichtungen bezeichnet, die unter 2kg, vorzugsweise unter 1kg, insbesondere unter 0,5kg Masse aufweisen. Vorzugsweise ist die Baugruppe für die Verwendung in einem lokalen Sicherheitsnetzwerk zur Überwachung von Türen o.ä. ausgebildet.

Weiterer Gegenstand der Erfindung ist ein Verfahren mit den Merkmalen des Anspruchs 10 zur Umschaltung des Betriebszustandes einer Baugruppe, wobei die Baugruppe insbesondere wie vorstehend erläutert ausgebildet ist.

Erfindungsgemäß weist die Baugruppe Zuleitungen für die Versorgungsspannung auf und die Umschaltung erfolgt durch ein insbesondere kurzzeitiges Umpolen der Versorgungsspannung.

Weitere Merkmale und Vorteile der Erfindung ergeben sich aus der nachfolgenden Beschreibung und den beigefügten Figuren von einem Ausführungsbeispiel der erfindungsgemäßen Baugruppe. Dabei zeigen:
- Figur 1: einen schematisierten Schaltplan eines ersten Ausführungsbeispiels der Erfindung;
- Figur 2: einen schematisierten Schaltplan einer Modifikation des ersten Ausführungsbeispiels.

Gleiche oder entsprechende Teile sind in den Figuren jeweils mit den gleichen Bezugszeichen versehen.

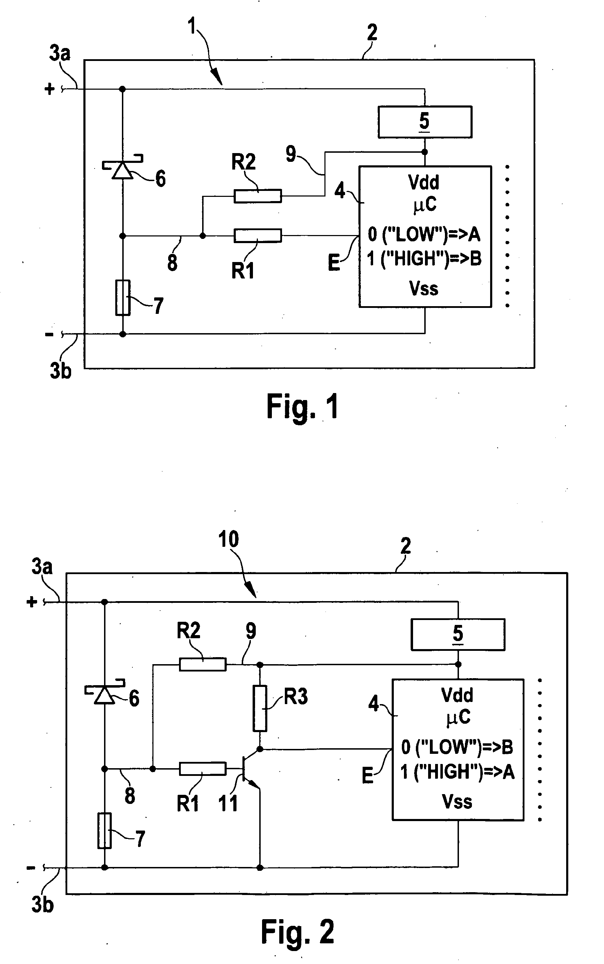

Die Figur 1 zeigt schematisiert und nur auf die wichtigsten Bauteile beschränkt einen Schaltplan einer Anpassungsschaltung 1 eines Niederspannungskleinstgerätes 2. Die Anpassungsschaltung 1 sowie weitere Teile der Schaltung sind in dem Niederspannungskleinstgerät 2 in Kunststoff vergossen angeordnet, so dass ein mechanischer Zugriff oder Eingriff von außen auf die Anpassungsschaltung 1 nicht möglich ist.

Bei dem Niederspannungskleinstgerät 2 handelt es sich beispielsweise um einen elektronischen Magnetkontakt, der in LSN-Systemen (LokalesSicherheitsNetzwerk) eingesetzt wird und der zur Kommunikation mit dem LSN ausgebildet ist. Um den Magnetkontakt kompatibel mit früheren Versionen des LSN zu halten und somit nicht für jede Version des LSN eine eigene Variante des Magnetkontaktes auf Vorrat halten zu müssen, weist dieser Magnetkontakt die Anpassungsschaltung 1 auf, mit deren Hilfe das Übertragungsprotokoll des Magnetkontakts entweder für die aktuelle Version des LSN eingestellt ist oder auf die frühere Version des LSN umstellbar ist.

Das Niederspannungskleinstgerät 2 weist zwei Zuleitungen 3 a und b auf, die eine Niedergleichspannungsquelle (nicht dargestellt) mit dem Niederspannungskleinstgerät 2 und insbesondere mit der Anpassungsschaltung 1 verbinden. Die Zuleitung 3a ist dabei an dem Pluspol, die Zuleitung 3b an dem Minuspol angeschlossen.

Das Niederspannungskleinstgerät 2 weist implementiert in die Anpassungsschaltung 1 einen Mikrocontroller 4 auf, der zur Kommunikation mit dem LSN (nicht dargestellt) auf zwei verschiedene Protokolle A oder B zurückgreifen kann.

Die Auswahl des Protokolls erfolgt anhand des an einem Eingang E angelegten Signals. In diesem Ausführungsbeispiel wird beim Anlegen eines logischen "LOW"-Signals das Protokoll A und beim Anlegen eines logischen "HIGH"-Signals das Protokoll B von dem Mikrokontroller 4 ausgewählt und für die Kommunikation verwendet.

Zur Anpassung der durch die Zuleitungen 3 a und b angelegte Versorgungsspannung an den Mikrokontroller 4 ist eine interne Energieversorgung 5 vorgesehen. Die Zuleitungen 3 a und b sind kurzschlussartig über eine Serienschaltung von einer Diode 6 und einer Sicherung 7 verbunden. Die Diode 6 ist dabei derart geschaltet, dass bei korrektem Anlegen der Versorgungsspannung für den normalen Betrieb des Niederspannungskleinstgerätes 2 ein Stromfluss zwischen den Zuleitungen 3a und b über die Serienschaltung gesperrt, also unterbunden ist.

Zwischen Diode 6 und Sicherung 7 zweigt eine Signalleitung 8 ab und führt über einen ersten Widerstand R1 auf den Eingang E des Mikrocontrollers 4. Zudem existiert eine weitere Verbindungsleitung 9, die den Ausgang der Energieversorgung 5, der ein positives Potential aufweist, über einen zweiten Widerstand R2 mit der Signalleitung 8 verbindet.

Funktionell betrachtet wird in der dargestellten Anordnung von dem Mikrokontroller 4 das Protokoll A ausgeführt, da der Eingang E des Mikrocontrollers 4 über den Widerstand R1, die Sicherung 7 und die Zuleitung 3b mit dem Minuspol der nicht-gezeigten Spannungsquelle verbunden ist und der Eingang E somit auf einem "LOW" - Potential liegt.

Zum Umschalten des Mikrocontrollers 4 auf das Protokoll B wird das Niederspannungskleinstgerät 2 an der nicht-gezeigten Spannungsquelle kurzzeitig verpolt angelegt, so dass die Zuleitung 3a mit dem Minuspol und die Zuleitung 3b mit dem Pluspol verbunden ist. In dieser Anordnung wird die Diode 6 in Durchlassrichtung betrieben, so dass ein Stromimpuls, insbesondere ein Kurzschlussstrom, über die Diode 6 und die Sicherung 7 fließt und die Sicherung 7 durchbrennt. Die Sicherung 7 ist dabei auf die Spannungsquelle so abgestimmt, dass für das Durchbrennen der Sicherung 7 eine bestimmte Zeit benötigt wird und ein unbeabsichtigtes kurzes Verpolen nicht zu einer Veränderung der Sicherung 7 führt.

Nach der irreversiblen Änderung der Sicherung 7 durch Durchschmelzen oder Durchbrennen und nachfolgender Zurückpolung der Spannungsquelle in die in der Figur 1 gezeigten Anordnung ist die Sicherung 7 dauerhaft und irreversibel geschmolzen, so dass an dieser Stelle eine Unterbrechung der Leitungen vorliegt. Im Betrieb ist nun der Eingang E des Mikrocontrollers 4 über die Widerstände R1 und R2 mit dem Ausgang der Energieversorgung 5, der ein positives Potential aufweist, verbunden, so dass an dem Eingang E ein "HIGH" - Potential anliegt und von dem Mikrocontroller 4 das Protokoll B verwendet wird. Die Umschaltung von Protokoll A zu Protokoll B ist irreversibel und kann nicht mehr rückgängig gemacht werden.

Die Figur 2 zeigt eine Modifikation auf Basis des Ausführungsbeispiels in Figur 1, welches im Gegensatz zu der Anpassungsschaltung 1 in der Figur 1 zusätzlich eine Invertierung des Logikzustandes aufweist. Der prinzipielle Aufbau der Schaltung 10 in Figur 2 ist ähnlich wie der von der Anpassungsschaltung 1 in Figur 1 und zeigt in gleicher Anordnung die Zuleitungen 3a und b, den Mikrocontroller 4, die Energieversorgung 5, die Diode 6, die Sicherung 7, die Signalleitung 8 sowie die Verbindungsleitung 9.

Im Gegensatz zu der Schaltung 1 ist der Mikrocontroller 4 in der Schaltung 10 aber ausgebildet und/oder programmiert, dass bei einem logischen "HIGH" an dem Eingang E das Protokoll A und bei Anliegen eines logischen "LOW" das Protokoll B ausgeführt wird.

Zur Invertierung ist ein npn-Transistor 11 integriert, dessen Basis mit der Signalleitung 9 nach dem Widerstand R1, dessen Kollektor über einen dritten Widerstand R3 zusammen mit der Verbindungsleitung 9 mit der Energieversorgung 5 und dessen Emitter mit der Zuleitung 3b kontaktiert ist. Zudem ist der Kollektor des Transistors 11 mit dem Eingang E des Mikrocontrollers 4 verbunden.

Solange die Sicherung 7 in der gezeigten Anordnung unzerstört ist, liegt an der Basis des Transistors 11 ein negatives Potential an und ein Stromfluss zwischen Kollektor und Emitter wird unterbunden, so dass an dem Eingang E über den Widerstand R3 ein positives oder "HIGH"-Potential anliegt und das Protokoll A aktiv ist.

Sobald nach einer kurzzeitigen Umpolung der Spannungsquelle die Sicherung 7 zerstört ist, liegt an der Basis des Transistors 11 über die Widerstände R2 und R1 ein positives Potential an und die Verbindung zwischen Kollektor und Emitter wird leitend geschalten, so dass an dem Eingang E des Mikrocontrollers 4 das "LOW" - Potential des Minuspols der Spannungsquelle anliegt und das Protokoll B aktiviert ist.

Insbesondere für den Fall, dass zwischen den Zuleitungen 3 a und b eine Schutzdiode zum Schutz der Spannungsquelle geschaltet ist, wird für die Diode 6 zweckmäßigerweise eine Schottky-Diode gewählt, da diese wegen ihrer kleinen Durchlassspannung einen größeren Strom erlaubt ohne die Schutzdiode durchzuschalten. Soll die Schaltung für kleinsten Platzbedarf angepasst werden, so wird als Sicherung 7 bevorzugt eine SMD-Schmelzsicherung eingesetzt.

Prinzipiell ist es möglich statt einer Diode 7 einen Kondensator einzusetzen und die Umschaltung statt durch Umpolung durch Anlegen einer Wechselspannung zu erreichen. Es sollte somit verständlich sein, dass das beschriebene Ausführungsbeispiel nur exemplarischen Charakter für die in den Ansprüchen dargelegte Erfindung haben kann.

## Patentansprüche

1. Baugruppe (2) mit einer mechanisch unzugänglich oder schwer zugänglich angeordneten Schaltung (1), die ein durch einen Stromimpuls irreversibel änderbares elektrisches Bauteil (7) aufweist, wobei durch die irreversible Änderung des Bauteils (7) die Schaltung (1) von einem ersten Betriebszustand in einen zweiten Betriebszustand umschaltbar ist, wobei die Baugruppe (2) mechanisch zugängliche Zuleitungen (3a,b) aufweist,
**dadurch gekennzeichnet,**
**dass** über die mechanisch zugänglichen Zuleitungen (3a,b)der Stromimpuls zur irreversiblen Änderung des elektrischen Bauteils (7) zuführbar ist.

2. Baugruppe (2) nach Anspruch 1, **dadurch gekennzeichnet, dass** die Zuleitungen (3a,b) mit mindestens zweifacher elektrische Funktion ausgebildet sind, wobei eine erste elektrische Funktion mit der Zuführung des Stromimpulses realisiert ist.

3. Baugruppe (2) nach Anspruch 2, **dadurch gekennzeichnet, dass** die zweite elektrische Funktion mit der Zuführung einer Versorgungsspannung realisiert ist.

4. Baugruppe (2) nach einem der vorhergehenden Ansprüche, **dadurch gekennzeichnet, dass** die Schaltung (1) ausgebildet ist, so dass durch Umpolung der Zuleitungen, insbesondere durch Umpolung der Versorgungsspannungszuleitungen (3a,b), die irreversible Änderung des Bauteils (7) erfolgt.

5. Baugruppe (2) nach einem der vorhergehenden Ansprüche, **dadurch gekennzeichnet, dass** das Bauteil als Schmelzsicherung (7) ausgebildet ist.

6. Baugruppe (2) nach einem der vorhergehenden Ansprüche, **dadurch gekennzeichnet, dass** der Stromimpuls über eine Serienschaltung eines internen Selektionselements (6) und des elektrischen Bauteils (7) führbar ist und/oder geführt wind.

7. Baugruppe (2) nach einem der vorhergehenden Ansprüche, **dadurch gekennzeichnet, dass** die Änderung des Betriebszustandes über eine Änderung eines Logikzustandes erfolgt.

8. Baugruppe (2) nach Anspruch 7, **dadurch gekennzeichnet, dass** einem Eingang (E) zur Änderung des Logikzustandes ein Transistor (11) zur Invertierung des Logikzustandes vorgeschaltet ist.

9. Baugruppe (2) nach einem der vorhergehenden Ansprüche, **dadurch gekennzeichnet, dass** die Baugruppe (2) als gekapseltes Klein- und/oder Niederspannungsgerät ausgebildet ist.

10. Verfahren zur Umschaltung des Betriebszustandes einer Baugruppe (2) nach einem der Ansprüche 1 bis 9 mit Zuleitungen (3a,b) für die Versorgungsspannung, **dadurch gekennzeichnet, dass** die Umschaltung durch Umpolen der Versorgungsspannung erfolgt.

## Claims

1. Assembly (2) having a circuit (1) which is arranged such that it is mechanically inaccessible or difficult to access and has an electrical component (7) which can be irreversibly changed by a current pulse, the circuit (1) being able to be changed over from a first operating state to a second operating state by irreversibly changing the component (7), the assembly (2) having mechanically accessible leads (3a, b),
**characterized in that**
the current pulse for irreversibly changing the electrical component (7) can be supplied via the mechanically accessible leads (3a, b).

2. Assembly (2) according to Claim 1, **characterized in that** the leads (3a, b) have at least a dual electrical function, a first electrical function being implemented with the supply of the current pulse.

3. Assembly (2) according to Claim 2, **characterized in that** the second electrical function is implemented with the supply of a supply voltage.

4. Assembly (2) according to one of the preceding claims, **characterized in that** the circuit (1) is designed such that the component (7) is irreversibly changed by reversing the polarity of the leads, in particular by reversing the polarity of the supply voltage leads (3a, b).

5. Assembly (2) according to one of the preceding claims, **characterized in that** the component is in the form of a fuse (7).

6. Assembly (2) according to one of the preceding claims, **characterized in that** the current pulse can be led and/or is led via a series circuit comprising an internal selection element (6) and the electrical component (7).

7. Assembly (2) according to one of the preceding claims, **characterized in that** the operating state is changed by changing a logic state.

8. Assembly (2) according to Claim 7, **characterized in that** a transistor (11) for inverting the logic state is connected upstream of an input (E) for changing the logic state.

9. Assembly (2) according to one of the preceding claims, **characterized in that** the assembly (2) is in the form of an encapsulated low-voltage device.

10. Method for changing over the operating state of an assembly (2) according to one of Claims 1 to 9 with leads (3a, b) for the supply voltage, **characterized in that** the changeover operation is carried out by reversing the polarity of the supply voltage.

## Revendications

1. Module (2) doté d'un circuit (1) mécaniquement inaccessible ou difficilement accessible, comportant un composant électrique (7) pouvant être modifié de manière irréversible au moyen d'une impulsion électrique, le circuit (1) pouvant être commuté d'un premier état de fonctionnement à un deuxième état de fonctionnement par la modification irréversible du composant (7), le module (2) comportant des lignes de raccordement (3a, b) mécaniquement accessibles,
**caractérisé en ce qu'**on peut acheminer l'impulsion électrique pour la modification irréversible du composant électrique (7) par l'intermédiaire des lignes de raccordement (3a, b) mécaniquement accessibles.

2. Module (2) selon la revendication 1, **caractérisé en ce que** les lignes de raccordement (3a, b) sont développées avec une fonction électrique au moins double, dans lequel une première fonction électrique est réalisée avec l'acheminement de l'impulsion électrique.

3. Module (2) selon la revendication 2, **caractérisé en ce que** la deuxième fonction électrique est réalisée avec l'acheminement d'une tension d'alimentation.

4. Module (2) selon une des revendications précédentes, **caractérisé en ce que** le circuit (1) est développé de telle sorte que l'inversion de la polarité des lignes de raccordement, notamment l'inversion de la polarité des lignes de raccordement de la tension d'alimentation (3a, b) entraîne la modification irréversible du composant (7).

5. Module (2) selon une des revendications précédentes, **caractérisé en ce que** le composant (7) est développé sous forme de fusible.

6. Module (2) selon une des revendications précédentes, **caractérisé en ce que** l'impulsion électrique peut être acheminée et/ou est acheminée par l'intermédiaire d'un branchement en série d'un élément interne de sélection (6) et du composant électrique (7).

7. Module (2) selon une des revendications précédentes, **caractérisé en ce que** la modification de l'état de fonctionnement s'effectue par l'intermédiaire d'une modification d'un état logique.

8. Module (2) selon la revendication 7, **caractérisé en ce qu'**un transistor (11) pour inverser l'état logique est branché en amont d'une entrée (E) pour la modification de l'état logique.

9. Module (2) selon une des revendications précédentes, **caractérisé en ce que** le module (2) est développé sous la forme d'un dispositif encapsulé à faible et/ou à basse tension.

10. Procédé pour la commutation de l'état de fonctionnement d'un module (2) selon une des revendications 1 à 9 avec des lignes de raccordement (3a, b) pour la tension d'alimentation, **caractérisé en ce que** la commutation s'effectue par inversion de la polarité de la tension d'alimentation.
